# EUROPEAN PATENT APPLICATION

(11) **EP 4 701 151 A1**
(43) Date of publication of application: **25.02.2026**
(21) Application number: 25194078.9
(22) Date of filing: 05.08.2025
(51) Int. Cl.: H04L 43/50

(54) **DEVICE MODEL TESTING TOOL**

(30) Priority: 23.08.2024 US 202418813797
(71) Applicant: Schneider Electric USA, Inc., Andover, MA 01810 (US)
(72) Inventor: S, Naresh, Bangalore (IN)
(74) Representative: Manitz Finsterwald Patent- und Rechtsanwaltspartnerschaft mbB

(57) **Abstract**

An application or software tool is used for testing a device model with a physical device. The tool runs a test on the physical device, via the network connection, using an input of test data. The test data includes the input and a corresponding output value of the device model. The tool compares an output value of the physical device generated by the test with the output value of the device model to generate a result of the test. The results of the test are displayed on a display of a computing device.

## Description

### FIELD OF THE DISCLOSURE

The present disclosure generally relates to a tool for testing a device model with a physical device.

### BACKGROUND OF THE DISCLOSURE

In an Internet of Things (IoT) environment, a device model describes a smart device's capabilities to a software application. This model is structured as a set of interfaces which, for example, may define properties that represent the read-only or writable state of the device, telemetry fields that define the data emitted by the device, and commands that describe a function or operation that can be done on the device. In one example, the device model may be a non-relational noSQL database, such as a document-type database (e.g., JSON database), for access by software applications for the device.

In the context of EDM-PDM modeling, the accuracy of these device models may become more important because of increased complexity and demand for accurate modeling. However, presently the testing of device models is not scalable or user friendly for line of business (LOB) to ensure they are operating correctly.

### SUMMARY OF THE DISCLOSURE

Features of a device model test tool for testing device models are described and shown herein.

In one aspect, a method for testing a device model with a physical device via a network connection generally comprises: (a) accessing the physical device via the network connection; (b) running a test on the physical device, via the network connection, using an input of test data, the test data including the input and a corresponding output value of the device model; (c) comparing an output value of the physical device generated by the test with the output value of the device model to generate a result of the test; and (d) presenting, on a display of a computing device, the result of the test. Each of steps (a)-(d) is performed using a device model testing tool software application executed on the computing device.

In another aspect, a system generally comprises one or more computer processors. A memory contains computer program code that, when executed by operation of the one or more computer processors, performs an operation. The operation comprises: (a) accessing the physical device via a network connection; (b) running a test on the physical device, via the network connection, using an input of test data, the test data including the input and a corresponding output value of the device model; (c) comparing an output value of the physical device generated by the test with the output value of the device model to generate a result of the test; and (d) presenting, on a display of the computing device, the result of the test.

In yet another aspect, a non-transitory computer readable medium stores sequences of computer-executable instructions for testing a device model with a physical device via a network connection. The sequences of computer executable instructions include instructions that instruct at least one processor to: (a) access the physical device via the network connection; (b) run a test on the physical device, via the network connection, using an input of test data, the test data including the input and a corresponding output value of the device model; (c) compare an output value of the physical device generated by the test with the output value of the device model to generate a result of the test; and (d) present, on a display of a computing device, the result of the test.

### BRIEF DESCRIPTION OF THE DRAWINGS

FIG. 1 is a schematic representation of a system including a Device Model Testing tool for testing a Device Model.
FIG. 2 is a schematic representation of accessing the Device Model for testing by the Device Model Testing tool.
FIG. 3 is a flow diagram for testing the Device Model using the Device Model Testing tool.
FIG. 4 is a Discovery Page of an exemplary User Interface of the Device Model Testing tool, including fields for inputting information for identifying one or more physical devices for testing.
FIG. 5 is similar to FIG. 4, but showing results of physical devices based on user's inputs.
FIG. 6 is similar to FIG. 5, but showing the selection of one of the physical devices for testing.
FIG. 7 is a Testing Page of the exemplary User Interface of the Device Model Testing tool, including clickable icons.
FIG. 8 is an exemplary results chart showing results of a test run by the Device Model Testing tool which can be displayed on the Testing Page.

### DETAILED DESCRIPTION OF THE DISCLOSURE

The present disclosure relates to an application or software tool for testing a device model with a physical device (hereinafter, the "Device Model Testing tool" or "DMT tool"). The DMT tool is scalable to enable testing of a large number of device models or if it is necessary to run tests on a regular basis. The DMT tool is capable of supporting a wide range of device models, such as but not limited to CAPI, Modbus and OPC-DA. In this way, an application or software may be tested on a variety of devices and ensure that it works properly on all of them. The DMT tool is easy to use, as it will be easily set up and capable of running tests without having to be an expert in device testing. Further, the DMT tool provides detailed reporting to help identify any problems with metadata or configurator data, for example, so that users can fix the device model before publishing. Overall, the creation of device models may become more complex and demanding. The present DMT tool enables accurate testing to ensure the device models are accurate and up-to-date, while enabling non-experts to readily test and troubleshoot the device models.

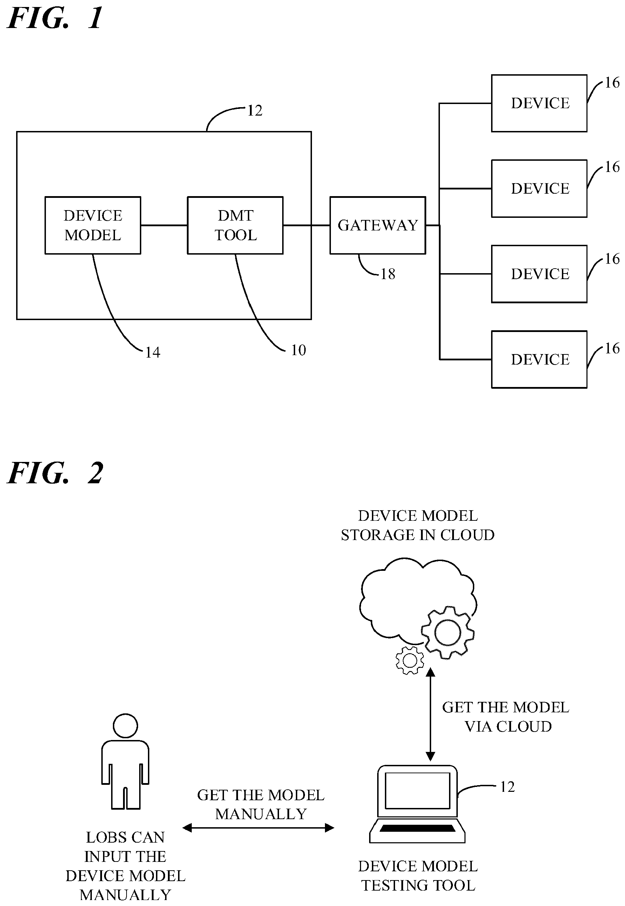

Referring to FIG. 1, a DMT tool 10 may be installed on a computing device 12, such as a laptop, hand-held mobile device, etc. As shown in FIG. 2, the device model(s) 14 for testing may be downloaded from the cloud or the device model(s) may be downloaded manually and saved to the computing device 12. In another example, the DMT tool 10 and its operation may be cloud-based, such that the DMT tool is run as a cloud-based application. In addition, the DMT tool may access the device model may from a cloud-based storage rather than from local storage. Thus, in one example, an entirety of the operation of testing of a device model using the DMT tool may be cloud-based.

The DMT tool 10 enables the user to discover and connect with one or more physical devices 16 (e.g., smart devices, such as smart meters, smart sensors, etc.) via a gateway 18 (e.g. Primary Access Server (PAS) gateway). The user may be prompted to enter an IP address, username, and password to grant access to the physical devices 16. The physical device(s) 16 may be a CAPI, Modbus, and/or OPC-DA. The DMT tool 10 may be configured to enable access to physical devices 16 in other ways.

The DMT tool 10 enables the user to select one or more physical devices 16 to which the user has access and for which the device model 14 will be tested. Once the one or more physical devices 16 are selected, the DMT tool 10 enables the user to run the testing. In one or more examples, the DMT tool 10 is programmed to run one or more of i) a Compatibility Test, ii) a Functional Test, and iii) an Edge and Boundary Test. During the Compatibility Test, the DMT tool 10 ensures that the device model 14 is correctly interpreted and executed by the physical device 16, and no conflicts or errors are produced. For example, a Model Sanity test, among others, may be performed by the DMT tool 10 as part of the Compatibility Test. For the Functional Test, the DMT tool 10 verifies that the device model 14 accurately performs its intended function. For example, the DMT tool 10 may test commands, actions, and responses as specified by the device model 14 against actual behavior of the physical device 16. As an example, the Functional Test run by the DMT tool 10 may include a Read and Write Services test. During the Edge and Boundary Test, the DMT tool 10 performs testing of edge cases and boundary conditions. For example, the DMT tool 10 examines possible scenarios where the device model 14 might behave unexpectedly or fail, including extreme input values or exceptional conditions.

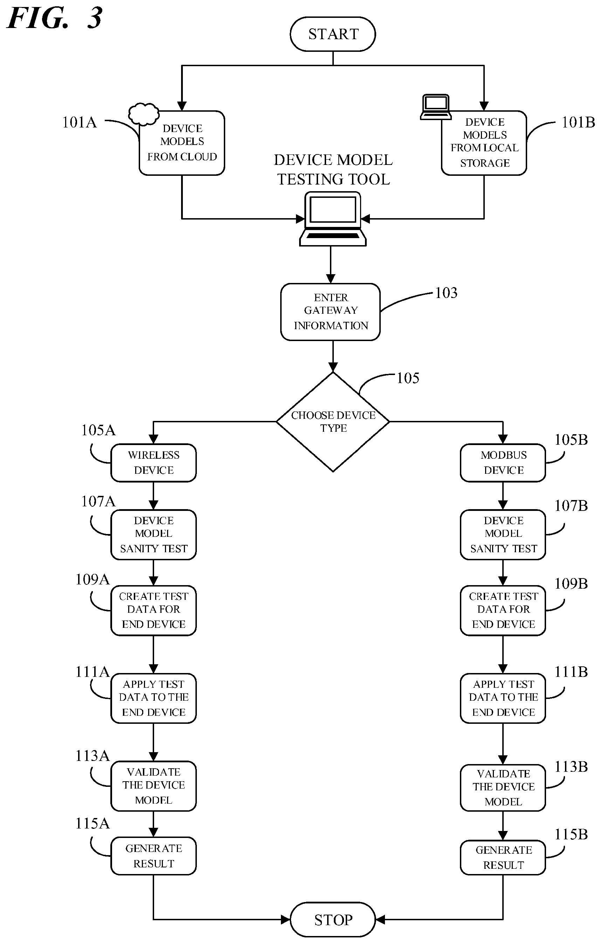

Referring to FIG. 3, a flow chart showing an exemplary operation of the DMT tool 10 is shown. At start and step 101A or 101B, the device model(s) 14 for testing are downloaded from the cloud or a local storage, respectively, to the computing system 12 for use by the DMT tool 10. This step is also shown schematically in FIG. 2. In particular, FIG. 2 illustrates the device model 14 being downloaded to the computing system either from the cloud or locally by the user. Referring back to FIG. 3, at step 103, The DMT tool 10 is connected to the applicable gateway 18, such as by entering the IP address and required credentials. At step 105A or 105B, the desired physical device 16 (e.g., wireless device or Modbus device) for testing is selected. At step 107A or 107A, the Compatibility Test is executed, which in this example, includes the Model Sanity test. Using the Model Sanity test, at step 109A or 109B, the DMT tool automatically creates test data for the physical device, and at step 111A or 111B, the DMT tool applies the test data to the physical device. At step 113A or 113B, the validates device model 14. For example, the functionality and correctness of read and write operations within a software system or application are validity. In other words, this testing ensures that the device model 14 accurately reflects the behavior and responses of the physical device 16 under different conditions and scenarios. This involves comparing the outputs and behaviors of the model 14 with those observed in real-world tests or data collected from the physical device 16. Finally, at step 115A or 115B, the result of the testing is generated. For example, if all of the physical device values equal the input values, then the device model 14 passes. The results of the testing can be presented in a table or spreadsheet, as described below, and the user can correct errors in the device model 14 based on the results of the testing.

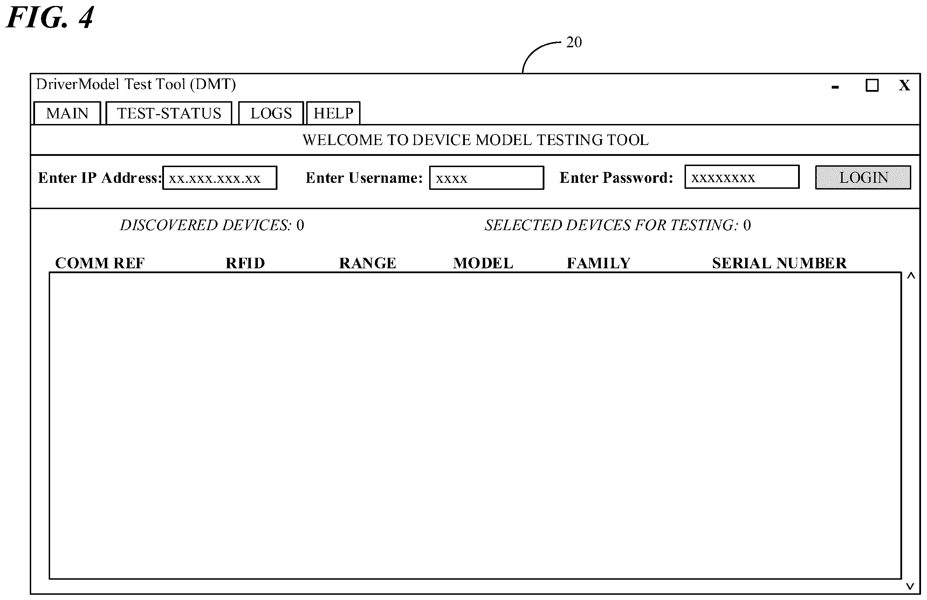

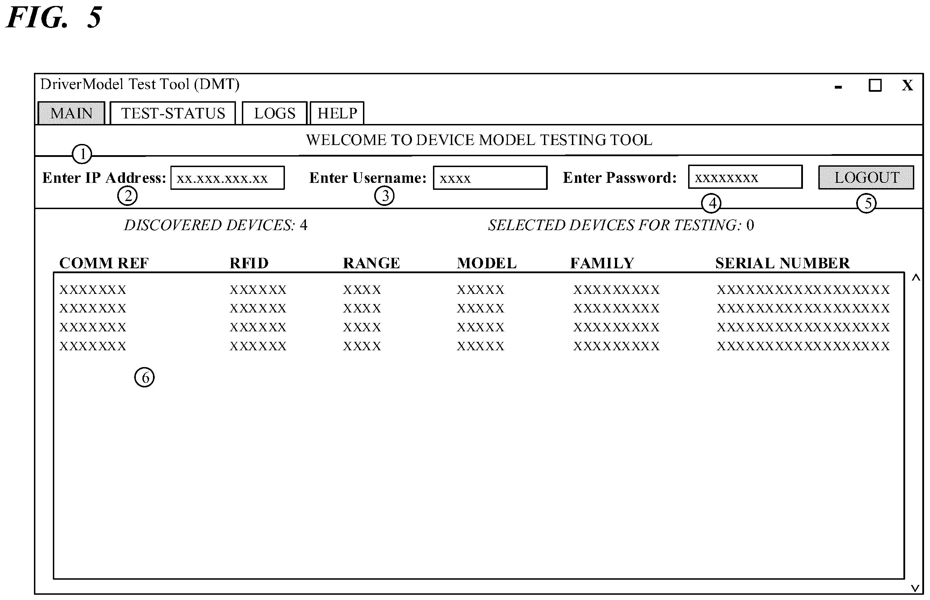

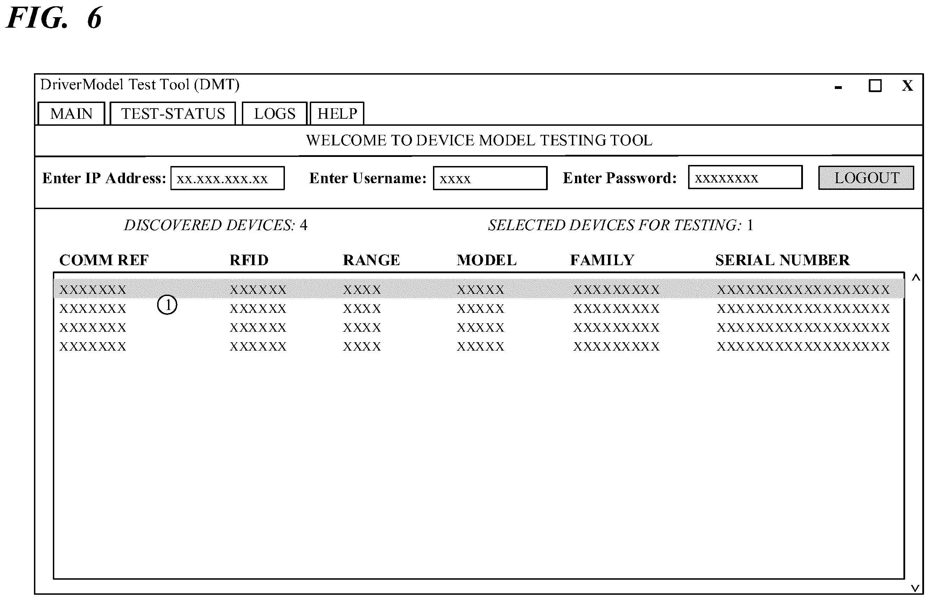

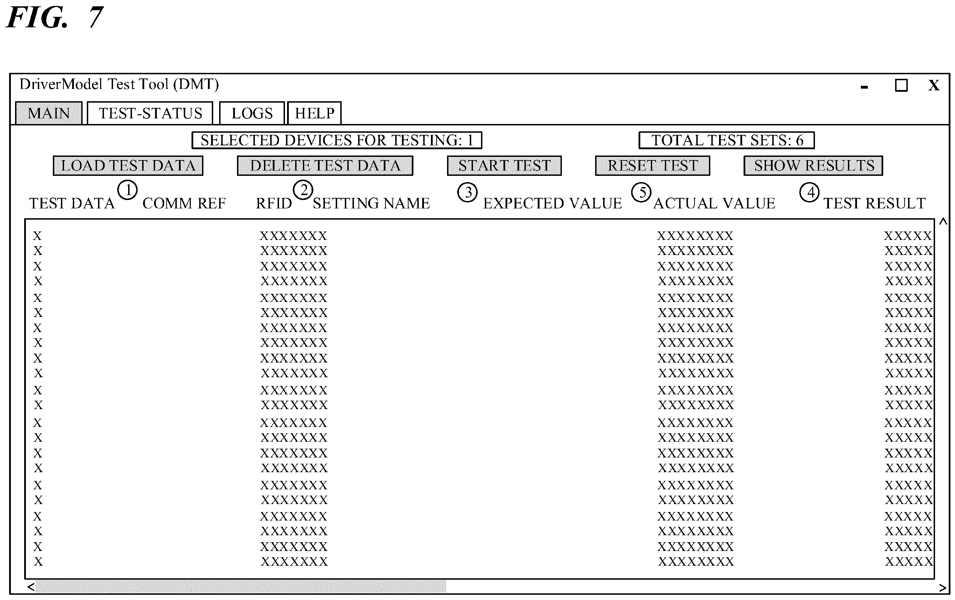

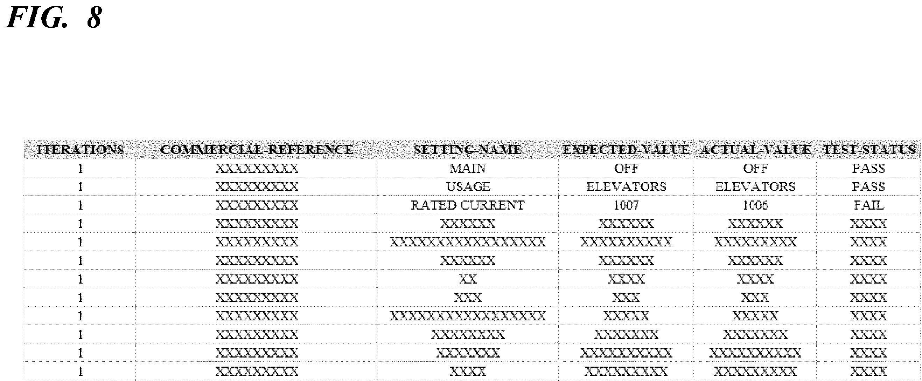

An exemplary User Interface (UI) 20 of the DMT tool 10 is shown in FIGS. 4-7. The UI 20 is divided into two main sections: the Discovery Page (FIGS. 4-6) and the Testing Page (FIGS. 7 and 8). On the Discovery page, the necessary parameters are configured before proceeding to testing. As shown in FIG. 4, for example, the page includes a field for the user to enter the IP address of the PAS gateway 18 (or PT Link gateway) to which the physical device 16 is connected, and fields for entering credentials (i.e., username and password) for accessing the PAS gateway. As shown in FIG. 5, after entering the information, the DMT tool 10 communicates with the PAS gateway 18 to discover all of the physical devices 16 connected to the PAS gateway. These physical devices 16 are displayed in a list on the page, as shown in FIG. 5. In the illustrated embodiment, each listed physical device 16 includes identification information regarding the particular device, including communication reference data, device model, family of the model, and serial number of the physical device. As shown in FIG. 6, the user selects one or more physical devices 16 from the list that will be used in the testing of the device model 14 via the DMT tool 10.

After selecting one or more connected physical devices used in the testing, the Testing Page is generated to enable the user to run the device model tests using the selected physical devices. As shown in FIG. 7, the Testing Page includes clickable icons for performing testing functions. In the illustrated embodiment, a clickable icon entitled "Load Test Data" enables a user to import pre-defined test data into the testing environment. In one or more embodiments, the pre-defined test data includes inputs and/or scenarios that the test will evaluate. The user selects one or more of the pre-defined test data, whereupon the selected pre-defined test data is loaded into the testing environment for additional configuration. After loading the test data, the testing may be initiated by clicking on the clickable icon entitled "Start Test." The DMT tool 10 runs the testing on the physical device 16 using the loaded test data. As shown in FIG. 7, the results of the tests are displayed on the Testing Page as a list. Referring to FIG. 8, data from an exemplary test is shown with results indicating pass/fail. Each result may be colored based on pass or fail result. For example, pass can be highlighted green, and failed can be highlighted red. The results may be displayed and communicated to the user in other ways. The DMT tool 10 enables a user to access more details regarding the results of the test, including pass/fail information, logs, and reports. This information is shown in the Testing Page when the user clicks the clickable icon "Show Results."

Referring to FIG. 7, in addition to the above functionality, the Testing Page enables the user to delete loaded test data by clicking the clickable icon entitled "Delete Test Data." Individual test data may be deleted or all of the selected test data may be deleted. The Testing Page also enables the user to reset the testing by clicking the clickable icon entitled "Reset Test." This operation will return the testing environment to its original state to enable the user to rerun the testing.

The illustrated UI of the DMT tool also includes a logs menu that provides the user with log entries of the DMT tool, including timestamps and descriptions. The logs menu enables the user to scroll through logs, search for specific entries, and/or filter logs based on criteria.

The disclosed DMT tool enables users who are not experts at testing devices easily set up and run tests using the physical device. The testing ensures that device models are up to the standard of the corresponding physical devices. The tool facilitates identification of any problems with configurator data or metadata of the device model so that these issues can be fixed. This tool is scalable in that a large number of device models may be tested and run on regular bases.

Having described the invention in detail, it will be apparent that modifications and variations are possible without departing from the scope of the invention defined in the appended claims.

Embodiments of the present disclosure comprise a special purpose computer including a variety of computer hardware, as described in greater detail herein and are operational with other special purpose computing system environments or configurations even if described in connection with an example computing system environment. The computing system environment is not intended to suggest any limitation as to the scope of use or functionality of any aspect of the invention. Moreover, the computing system environment should not be interpreted as having any dependency or requirement relating to any one or combination of components illustrated in the example operating environment. Examples of computing systems, environments, and/or configurations that may be suitable for use with aspects of the present disclosure include, but are not limited to, personal computers, server computers, hand-held or laptop devices, multiprocessor systems, microprocessor-based systems, set top boxes, programmable consumer electronics, mobile telephones, network PCs, minicomputers, mainframe computers, distributed computing environments that include any of the above systems or devices, and the like.

Aspects of the present disclosure may be described in the general context of data and/or processor-executable instructions, such as program modules, stored one or more tangible, non-transitory storage media and executed by one or more processors or other devices. Generally, program modules include, but are not limited to, routines, programs, objects, components, and data structures that perform particular tasks or implement particular abstract data types. Aspects of the present disclosure may also be practiced in distributed computing environments where tasks are performed by remote processing devices that are linked through a communications network. In a distributed computing environment, program modules may be located in both local and remote storage media including memory storage devices. For purposes of illustration, programs and other executable program components may be shown as discrete blocks. It is recognized, however, that such programs and components reside at various times in different storage components of a computing device, and are executed by a data processor(s) of the device.

In operation, processors, computers, and/or servers may execute the processor-executable instructions (e.g., software, firmware, and/or hardware) such as those illustrated herein to implement aspects of the invention. The processor-executable instructions may be organized into one or more processor-executable components or modules on a tangible processor readable storage medium. Also, embodiments may be implemented with any number and organization of such components or modules. For example, aspects of the present disclosure are not limited to the specific processor-executable instructions or the specific components or modules illustrated in the figures and described herein. Other embodiments may include different processor-executable instructions or components having more or less functionality than illustrated and described herein.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the present disclosure.

Not all of the depicted components illustrated or described may be required. In addition, some implementations and embodiments may include additional components. Variations in the arrangement and type of the components may be made without departing from the spirit or scope of the claims as set forth herein. Additional, different or fewer components may be provided and components may be combined. Alternatively, or in addition, a component may be implemented by several components.

Having described the invention in detail, it will be apparent that modifications and variations are possible without departing from the scope of the invention defined in the appended claims.

When introducing elements of the present invention or the preferred embodiment(s) thereof, the articles "a", "an", "the" and "said" are intended to mean that there are one or more of the elements. The terms "comprising", "including" and "having" are intended to be inclusive and mean that there may be additional elements other than the listed elements.

In view of the above, it will be seen that the several objects of the invention are achieved and other advantageous results attained.

As various changes could be made in the above products without departing from the scope of the invention, it is intended that all matter contained in the above description and shown in the accompanying drawings shall be interpreted as illustrative and not in a limiting sense.

The Abstract and Summary are provided to help the reader quickly ascertain the nature of the technical disclosure. They are submitted with the understanding that they will not be used to interpret or limit the scope or meaning of the claims. The Summary is provided to introduce a selection of concepts in simplified form that are further described in the Detailed Description. The Summary is not intended to identify key features or essential features of the claimed subject matter, nor is it intended to be used as an aid in determining the claimed subject matter.

## Claims

1. A method for testing a device model with a physical device via a network connection, comprising:
(a) accessing the physical device via the network connection;
(b) running a test on the physical device, via the network connection, using an input of test data, the test data including the input and a corresponding output value of the device model;
(c) comparing an output value of the physical device generated by the test with the output value of the device model to generate a result of the test; and
(d) presenting, on a display of a computing device, the result of the test,
wherein each of steps (a)-(d) is performed using a device model testing tool software application executed on the computing device.

2. The method according to claim 1, further comprising, before step (b), generating the test data from the device model.

3. The method according to claim 2, wherein said generating the test data includes selecting the input to run on the device model, and storing the selected input and corresponding output value of the device model.

4. The method according to claim 2 or 3, further comprising, before said generating the test data from the device model, accessing the device model from a cloud storage.

5. The method according to claim 2, 3 or 4, further comprising, before said generating the test data from the device model, accessing the device model from local storage of the computing device.

6. The method according to claim 3, 4 or 5, further comprising, before step (b) selecting the test data from pre-defined libraries of test cases.

7. The method according to any one of the preceding claims, wherein step (d) comprises generating a report on the test result, wherein the report includes one or more of pass/fail information, logs, and recommendations for improving the accuracy of the device model.

8. The method according to any one of the preceding claims, wherein the physical device is a smart device.

9. The method according to claim 8, wherein the physical device is a smart meter, smart breaker, or smart sensor.

10. The method according to any one of the preceding claims, wherein the device model testing tool software application is installed on the computing device.

11. The method according to any one of claims 1 to 9, wherein the device model testing tool software application is run on a cloud-based platform accessible by the computing device.

12. The method according to any one of the preceding claims, wherein step (a) comprises entering username and password information.

13. The method according to any one of the preceding claims, wherein step (a) comprises:
accessing a gateway in communication with the device and a plurality of other devices;
displaying, on the display of the computing device, a list of devices accessible via the gateway, wherein the list includes the device and the plurality of other devices.

14. A system, comprising: one or more computer processors; and a memory containing computer program code that, when executed by operation of the one or more computer processors, performs an operation, the operation comprising:
(a) accessing the physical device via a network connection;
(b) running a test on the physical device, via the network connection, using an input of test data, the test data including the input and a corresponding output value of the device model;
(c) comparing an output value of the physical device generated by the test with the output value of the device model to generate a result of the test; and
(d) presenting, on a display of the computing device, the result of the test.

15. A non-transitory computer readable medium storing sequences of computer-executable instructions for testing a device model with a physical device via a network connection, the sequences of computer executable instructions including instructions that instruct at least one processor to:
(a) access the physical device via the network connection;
(b) run a test on the physical device, via the network connection, using an input of test data, the test data including the input and a corresponding output value of the device model;
(c) compare an output value of the physical device generated by the test with the output value of the device model to generate a result of the test; and
(d) present, on a display of a computing device, the result of the test.
